**Europäisches Patentamt**

**European Patent Office**

**Office européen des brevets**

(11) Publication number: **0 098 051**
**B1**

# EUROPEAN PATENT SPECIFICATION

(45) Date of publication of patent specification: **31.01.90**

(51) Int. Cl.⁵: **H 01 L 23/31** // H01L23/48

(21) Application number: **83303116.4**

(22) Date of filing: **31.05.83**

(54) A plastics-encapsulated circuit element.

(30) Priority: **31.05.82 JP 91174/82**

(43) Date of publication of application:
**11.01.84 Bulletin 84/02**

(45) Publication of the grant of the patent:
**31.01.90 Bulletin 90/05**

(84) Designated Contracting States:
**DE FR GB**

(56) References cited:
**EP-A-0 090 439**
**EP-A-0 090 608**
**DE-A-2 653 833**
**US-A-3 574 815**
**IBM TECHNICAL DISCLOSURE BULLETIN, vol.
21, no. 7, December 1978, page 2917, NEW
YORK (US). CARBAUGH et al.: "Retarding
conductive paths between metal pads"**
**PATENTS ABSTRACTS OF JAPAN, vol. 5, no.
117, (E-67)(789), July 28, 1981 & JP A 5655065**
**PATENTS ABSTRACTS OF JAPAN, vol. 8, no. 8,
(E-221)(1445), January 13, 1984 & JP A
458173849**

(73) Proprietor: **KABUSHIKI KAISHA TOSHIBA
72, Horikawa-cho Saiwai-ku
Kawasaki-shi Kanagawa-ken 210 (JP)**

(72) Inventor: **Yasui, Mitsuru c/o Patent Division
Tokyo Shibaura Denki K.K. Horikawa-cho
Saiwai-ku Kawasaki-shi Kanagawa-ken (JP)**

(74) Representative: **Kirk, Geoffrey Thomas et al
BATCHELLOR, KIRK & EYLES 2 Pear Tree Court
Farringdon Road
London EC1R 0DS (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# EP 0 098 051 B1

**Description**

This invention relates to a plastic encapsulated device. Encapsulating with resin is widely used for various semiconductor elements including high voltage elements because the technique lends itself to simplicity and automation in manufacturing.

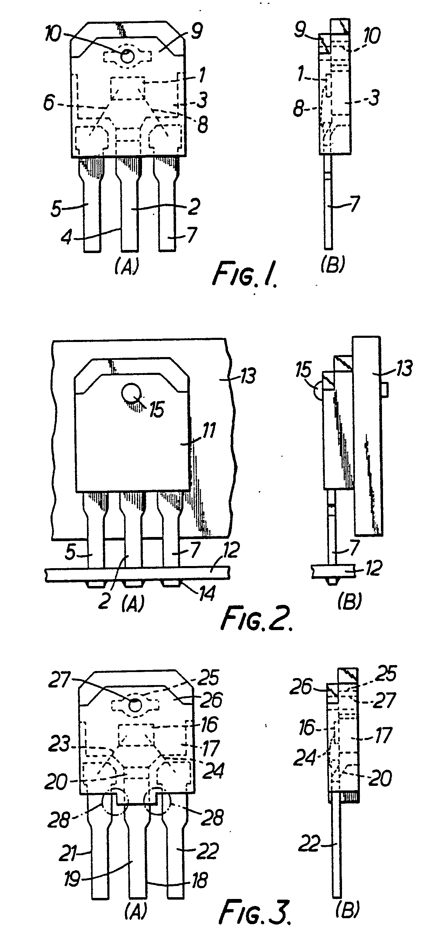

A prior art device is shown in Figures 1(A) and 1(B). A transistor chip 1 is mounted on a first lead 2. The transistor has a breakdown voltage of about 1500V, and is used in high voltage applications. The first lead 2 includes a mounting portion 3 on which the semiconductor chip is mounted and an external lead portion 4. The transistor chip 1 is bonded on the mounting portion 3 and its collector is electrically connected with the mounting portion 3. The base of the transistor 1 is connected with a second lead 5 through a wire 6 and the emitter of the transistor 1 is connected with a third lead 7 through a wire 8. The end portion of the leads 2, 5 and 7, as well as the chip 1, are enclosed in a plastic encapsulation 9, but a rear surface of the mounting portion 3 is exposed and a hole 10 is made in the plastic encapsulation 9. The hole 10 is used for fixing to an external heat radiation plate with a screw.

The practical application of the device in Figure 1 is shown in Figure 2. The device 11 is installed in a printed circuit board 12 and an external heat radiation plate 13.

The leads 2, 5 and 7 are secured to the printed board 12 with solder 14 and the body of the device 11 is secured to the external heat radiation plate 13 with a screw 15.

If high voltage is applied to the device 11 in a moist atmosphere, there is a danger that a current leakage passage is formed on the surface of the encapsulation between the leads 2 and 5 or the leads 2 and 7, and/or that a current leakage passage is similarly formed between the leads 2, 5 and 7 and the external heat radiation plate 13; the leads are closely arranged and the surface of the encapsulation 9 between them is planar and has a short surface distance, and a similar condition exists between the leads and the external heat radiation plate. Generally, the higher the applied voltage and the higher the moisture level, the greater is the leakage current. When leakage current between the leads occurs, the encapsulation 9 is heated by the leakage current and the plastic may be carbonized. Carbonized plastic is conductive, resulting in further increase in the current leak. Occasionally, smoke may be emitted and the plastic begin to burn. This may destroy the device including the encapsulated circuit element.

Moreover, some encapsulated circuit elements are used in desert conditions, where the devices may be subjected to humidity of more than 100% because of the difference of temperatures between the daytime and the night. Salt may be included in the moisture, when the leakage current is more likely to be formed because saline water is more conductive than pure water.

It is accordingly an object of the invention to provide a plastic encapsulated device having high reliability for use with high voltage.

The invention is concerned with a plastic encapsulated device comprising a circuit element having a plurality of terminals; leads connected with the terminals of the element; and a plastic encapsulation enclosing the element and a part of each lead. According to the invention as defined in claim 1, the surface of the encapsulation has steps in order to increase the leakage path from the lead or leads.

The invention will be more fully understood by way of example from the following description of encapsulated devices in accordance therewith, reference being made to the accompanying drawings, in which

Figure 1A and Figure 1B respectively show a front view and a side view of a prior device;

Figure 2A and Figure 2B respectively show a front view and a side view in which a prior device is installed on a printed board;

Figure 3A and Figure 3B respectively show a front view and a side view of a device according to a first embodiment (not claimed);

Figures 4A to 7A and Figures 4B and 7B respectively show front views and side views of embodiments of the invention;

Figures 8A, 8B and 8C respectively show a front view, a side view and a plan view of a prior device used for a comparative experiment on reliability; and

Figures 9A, 9B and 9C respectively show a front view, a side view and a plan view of an embodiment according to this invention used in the experiment.

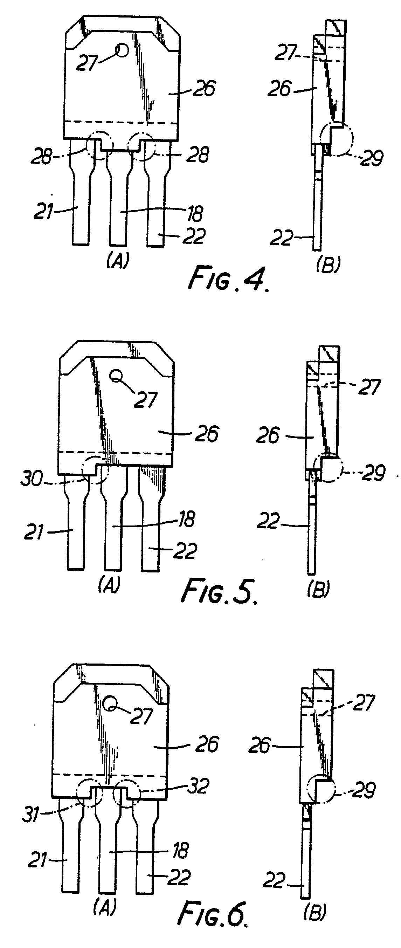

In Figures 3 to 9 of the drawings, like reference numerals designate identical or corresponding parts throughout the several views.

In the encapsulated device of Figures 3A and 3B (not claimed), a transistor chip 16 is mounted on a metal mounting portion 17 of a first lead 18. The transistor 16 has the breakdown voltage of about 1500V, and is intended for high voltage usage. The mounting portion 17 has a wide area and operates also as a heat radiation plate. An external lead portion 19 and a connecting portion 20 which connects the mounting portion 17 with the external lead portion 19, and includes a step portion, also form a part of the first lead 18. The mounting portion 17 is offset from the external lead portion 19 as shown in Figure 3B and a hole 25 is formed therein for installing the device on an external heat radiation plate. The collector of the transistor 16 is bonded to the mounting portion 17 and is electrically connected with the lead 18. The base and emitter of the transistor are respectively connected with a second lead 21 and a third lead 22 through gold wires 23 and 24. The gold wires 23 and 24 easily provide such connections without contact with the first lead 18 because the second and third leads 21 and 22 are positioned on different levels from the first lead 18.

2

During fabrication, the transistor chip 16, the mounting 17 and a part of each lead 19, 21 and 22 are placed in a mould, and resin injected to form the plastic encapsulation 26. Then, the rear of the mounting portion 17 (to the right in Figure 3B) is exposed in order to increase the efficiency of heat radiation. A hole 27 is formed in the plastic encapsulation 26 at a position coaxial with the hole 25.

The plastic encapsulation 26 has a configuration which differs from that of the prior device. In particular, a protruding part is formed by steps 28 in the surface of the encapsulation between the leads 18 and 21 and between the leads 18 and 22; those steps are shown in the drawings surrounded by interrupted circles. The steps 28 can be easily formed by changing the shape of the mould. The steps 28 increase the surface distance of the plastic encapsulation 26 between the leads 18 and 21 and the leads 18 and 22 and increase the surface leakage path between adjacent leads. Therefore, the leakage current between the leads is less likely to flow even if moisture adheres to the surface of the plastic encapsulation 26. Generally, moisture will be concentrated in the gaps formed by the steps 28 between the plastic encapsulation 26 and the lead 21 or 22, and will not easily adhere around the lead 18 due to the existence of the protruding part of the encapsulation at the lead 18.

In the embodiment shown in Figures 4A and 4B, the semiconductor has the same structure as the element 16, but its encapsulation 26 has a different configuration. In particular, a step 29 is formed on the back of the plastic encapsulation 26, between the face at which the mounting 17 is exposed and the side through which the leads 18, 21 and 22 emerge. A notch or slot is defined jointly by this step and an external radiation plate when the device is installed on the external heat radiation plate, as explained in Figure 2. In this case, the step 29 defines a longer surface distance between the leads 21 and 22 and the external heat radiation plate. Therefore, even if a high voltage is applied between the leads 21 and 22 and the external heat radiation plate, which usually has the same voltage as the collector of the transistor 16, a leakage current path is not readily formed because the surface distance of the plastic encapsulation 26 therebetween is longer and the moisture will concentrate in the notch defined at 29.

In the embodiment of Figures 5(A) and 5(B), steps 30 and 29 are formed only between leads 18 and 21 and on the back of a plastic encapsulation 26. In the case of a high voltage transistor, the voltage between the collector and base is much higher than that between the collector and emitter. This means that a leakage current path is liable to be formed between the leads 18 and 21 which are, respectively, connected with the collector and base of the transistor 16. Therefore, the step 30 is formed only between the leads 18 and 21, and is not formed between the leads 18 and 22.

In Figures 6(A) and 6(B), steps 29, 31 and 32 are formed between leads 18, 21 and 22 and on the back of the plastic encapsulation 26 in a manner similar to the embodiment of Figure 4. But the shape of the step portions 31 and 32 is opposite to that of Figure 4. The surface of the plastic encapsulation 26 around the lead 18 is recessed to form the steps at 31 and 32. But, its function and advantage are the same as those of Figure 4.

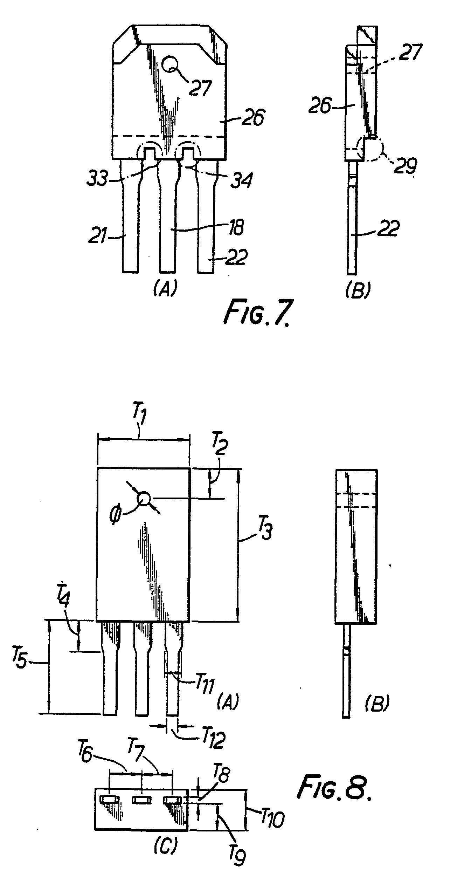

In Figures 7(A) and 7(B), grooves 33 and 34, each including two step portions, are formed between leads 18, 21 and leads 18, 22 instead of a single notch. The grooves 33 and 34 increase the surface distance of the plastic encapsulation 26 between consecutive leads 18, 21 and 22, and moisture concentrates therein. Therefore leakage current between the leads 18, 21 and 22 is less likely to flow, compared with the other embodiments, while the face of the plastic encapsulation 26 for each of the leads 18, 21 and 22 is in the same plane. The width of the grooves 33 and 34 must be small, necessitating a special mould.

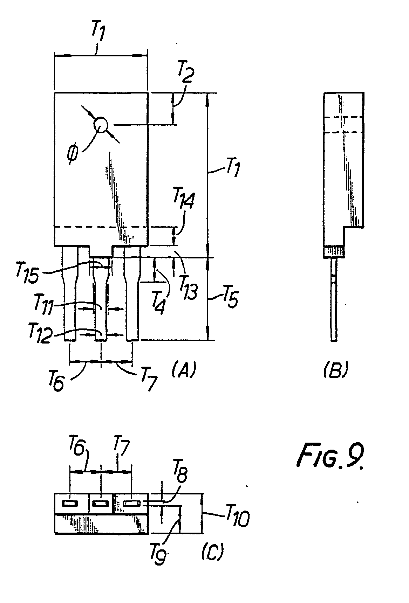

Reliability experiments to compare the performance of a device of this invention and a prior art device have been conducted. Figure 8 shows the prior art device used in the experiments, and Figure 9 shows a device according to the present invention. The transistor used in these devices had the breakdown voltage of 1500V and the sizes of the parts of the two devices are shown in Table 1. The devices were installed as shown in Figure 2. First, the devices were arranged near the ventilation gate of a humidifier so that the humidity was about 100%, and a fixed voltage of 1500V applied between base and collector of each transistor. Moreover, more small drops of water are blown against the devices. In this state, the time at which leakage current between the leads becomes more than 5 mA was measured. It was found that the time necessary for this degree of leakage to occur in the device according to this invention was longer than that in the prior device, as shown in Table 2.

Next, a pulse voltage having a peak voltage of 1100V and a cycle of 63.5 micro seconds was applied to the same devices in the same environment and the times at which the two leads became short-circuited were measured. It was found that the time necessary for this to occur in the device according to this invention is longer than that in a prior device as shown in Table 3.

As illustrated by these results, a device according to this invention may have a reliability of three times to six time that of the prior art for a fixed voltage and one point four times to about twice that of the prior art for pulse voltage. This invention can be used for a plasteic encapsulating device in which a plurality of external leads are closely arranged.

Obviously, many modifications and variations of this invention are possible in the light of the above teachings. It is therefore to be understood that within the scope of the appended claims, the invention may be practiced otherwise than as specifically described herein.

# EP 0 098 051 B1

### TABLE 1
### The size of the device

| | The device of Figure 8 | The device of Figure 9 |
|---|---|---|
| $T_1$ | 15.9 | 15.5 |
| $T_2$ | 4.5 | 4.5 |
| $T_3$ | 20.0 | 25.0 |
| $T_4$ | 3.3 | 1.5 |
| $T_5$ | 13.5 | 19.0 |
| $T_6$ | 5.45 | 5.45 |
| $T_7$ | 5.45 | 5.45 |
| $T_8$ | 0.4 | 0.6 |
| $T_9$ | 2.8 | 2.8 |
| $T_{10}$ | 4.8 | 5.0 |
| $T_{11}$ | 2.0 | 2.0 |
| $T_{12}$ | 1.0 | 1.0 |
| $T_{13}$ | | 2.0 |
| $T_{14}$ | | 2.0 |
| $T_{15}$ | | 2.0 |
| $\phi$ | 3.2 | 3.6 |

### TABLE 2

| Test device | Time |
|---|---|
| The prior device | 3 minutes and 49 seconds to 4 minutes and 5 seconds |
| The device according to this invention | 14 minutes and 20 seconds to 19 minutes and 20 seconds |

### TABLE 3

| The prior device | 16 minutes and 50 seconds to 24 minutes and 32 seconds |
|---|---|
| The device according to the invention | More than 30 minutes |

## Claims

1. A plastic encapsulated device comprising a circuit element (16) having a plurality of terminals; at least two adjacent leads (18, 21, 22) connected with the terminals of the element (16) and closely arranged

4

to each other and a plastic encapsulation (26) enclosing the element (16) and a part of each lead (18, 21, 22) and having a surface installed on an external plate; characterised in that the external surface of the encapsulation (26) has two step portions (28, 29) in order to increase the leakage path from the lead, wherein the one step portion (28) is formed between at least two adjacent leads (18, 21, and/or 19, 22) and the other step (29) is formed between the leads (18, 21, 22) and the surface of the encapsulation (26) installed on the external plate.

2. A plastic encapsulated device according to claim 1, in which the or each step is constituted by a groove (33, 34) in the surface of the encapsulation (26) between two adjacent leads (18, 21 and 18, 22).

3. A plastic encapsulated device according to claim 1 or claim 2, in which the encapsulation (26) has two opposing surfaces connected by side surfaces, from one of which the leads (18, 21, 22) extend and the step (29) is formed between that side surface and one of the opposing surfaces.

4. A plastic encapsulated device according to claim 3, in which the leads (18, 21, 22) extend from the side surface adjacent to one of the opposing surfaces.

5. A plastic encapsulated device according to any one of the preceding claims, in which the element (16) is a transistor and the leads (18, 21, 22) are respectively connected with the emitter, base and collector of the transistor.

6. A plastic encapsulated device according to claim 5, in which a step (28) is formed between the leads (18, 21) connected with the base and collector.

7. A plastic encapsulated device according to any one of the preceding claims, in which a mounting hole (27) is formed in the encapsulation (26) for installing the device on an external plate.

## Patentansprüche

1. Kunststoffverkapselte Einrichtung mit einem Schaltungselement mit mehreren Anschlüssen, mit wenigstens zwei benachbarten Leitern (18, 21, 22), die mit den Anschlüssen des Schaltungselements (16) verbunden sind und nahe zueinander und zu einer Kunststoffverkapselung (26) angeordnet sind, die das Element (16) und einen Teil der Leiter (18, 21, 22) umgibt und eine auf einer äußeren Platte angeordnete Fläche aufweist, dadurch gekennzeichnet, daß die äußere Fläche der Verkapselung (26) zwei Stufenabschnitte (28, 29) aufweist, um die Kriechstrecke vom Leiter zu erhöhen, wobei ein gestufter Abschnitt (28) zwischen wenigstens zwei benachbarten Leitern (18, 21 und/oder 19, 22) ausgebildet ist und die andere Stufe (29) zwischen den Leitern (18, 21, 22) und der Oberfläche der Verkapselung (26) ausgebildet ist, die auf der äußeren Platte installiert ist.

2. Kunststoffverkapselte Einrichtung nach Anspruch 1, bei dem jede Stufe gebildet wird durch eine Ausnehmung (33, 34) in der Fläche der Verkapselung (26) zwischen zwei benachbarten Leitern (18, 21 und 18, 22).

3. Kunststoffverkapselte Einrichtung nach Anspruch 1 oder 2, bei dem die Verkapselung (26) zwei gegenüberliegende, durch die Seitenfläche verbundene Flächen aufweist, wobei von einer dieser Flächen die Leiter (18, 21, 22) abgehen und die Stufe (29) zwischen dieser Seitenfläche und einer der gegenüberliegenden Flächen ausgebildet ist.

4. Kunstestoffverkapselte Einrichtung nach Anspruch 3, bei der die Leiter (18, 21, 22) von der Seitenfläche ausgehen, die benachbart zu einer der gegenüberliegenden Flächen angeordnet ist.

5. Kunststoffverkapselte Einrichtung nach einem der vorhergehenden Ansprüche, bei der das Element (16) ein Transistor und die Leiter (18, 21, 22) mit dem Emitter, der Basis und dem Kollektor des Transistors verbunden sind.

6. Kunststoffverkapselte Einrichtung nach Anspruch 5, bei der eine Stufe (28) zwischen den Leitern (18, 21) ausgebildet ist, die mit der Basis und dem Kollektor verbunden sind.

7. Kunststoffverkapselte Einrichtung nach einem der vorhergehenden Ansprüche, bei der eine Montageöffnung (27) in der Verkapselung (26) ausgebildet ist zur Anbringung der Einrichtung auf einer äußeren Platte.

## Revendications

1. Dispositif de circuit encapsulé qui comprend un élément de circuit (16) ayant plusieurs bornes de sortie; au moins, deux conducteurs adjacents (18, 21, 22) connectés aux bornes de sortie de l'élément (16) et qui sont proches l'une de l'autre et un enrobage de matière plastique (268) entourant l'élément (16) et une partie de chaque conducteur (18, 21, 22) et ayant une surface montée sur une plaque extérieure, caractérisé en ce que la surface extérieure de l'enrobage (26) possède deux gradins (28, 29) visant à allonger la voie de fuite électrique du conducteur, l'un des gradins (28) étant formé entre, au moins, deux conducteurs adjacents (18, 21 et/ou 19/22) tandis que l'autre gradin (29) est formé entre les conducteurs (18, 21, 22) et la surface de l'enrobage (268) situé sur la plaque extérieure.

2. Dispositif de circuit encapsulé selon la revendication 1, caractérisé en ce que le ou chaque gradin est constitué par une rainure (33, 34) creusée dans la surface de l'enrobage (26) entre les conducteurs adjacents (18, 21 et 18, 22).

3. Dispositif de circuit encapsulé selon la revendication 1 ou 2, caractérisé en ce que l'enrobage (26) présente deux surfaces opposées reliées par des surfaces latérales de l'une desquelles s'étendent les conducteurs (18, 21, 22), tandis que le gradin (29) est formé entre cette surface latérale et l'une des surfaces opposées.

4. Dispositif de circuit encapsulé selon la revendication 3, caractérisé en ce que les conducteurs (18, 21, 22) s'étendent de la surface latérale adjacente à l'une des deux surfaces opposées.

5. Dispositif de circuit encapsulé selon l'une quelconque des revendications précédentes, caractérisé en ce que l'élément (16) est un transistor et en ce que les conducteurs (18, 21 et 22) sont respectivement connectés à l'émetteur, à la base et au collecteur dudit transistor.

6. Dispositif de circuit encapsulé selon la revendication 5, caractérisé en ce que le gradin (28) est formé entre les conducteurs (18, 21) connectés à la base et au collecteur.

7. Dispositif de circuit encapsulé selon l'une quelconque des revendications précédentes, caractérisé en ce qu'un trou de montage (27) est percé dans l'enrobage (26) pour monter le dispositif sur une plaque extérieure.

*Fig. 1.*

(A)   (B)

*Fig. 2.*

(A)   (B)

*Fig. 3.*

(A)   (B)

1

FIG.4.

(A)    (B)

FIG.5.

(A)    (B)

FIG.6.

(A)    (B)

2

FIG.7.

FIG.8.

3

FIG.9